(19) **Europäisches Patentamt / European Patent Office / Office européen des brevets**

(11) **EP 2 786 497 B1**

(12) **FASCICULE DE BREVET EUROPEEN**

(45) Date de publication et mention de la délivrance du brevet:
**10.08.2016 Bulletin 2016/32**

(51) Int Cl.:
**H03M 13/13** *(2006.01)* **G06F 11/10** *(2006.01)*

(21) Numéro de dépôt: **12784595.6**

(86) Numéro de dépôt international:
**PCT/EP2012/072392**

(22) Date de dépôt: **12.11.2012**

(87) Numéro de publication internationale:
**WO 2013/079306 (06.06.2013 Gazette 2013/23)**

(54) **PROCEDE DE MAXIMISATION DE LA CAPACITÉ DE CORRECTION D'UN CODE CORRECTEUR D'ERREURS METTANT EN OEUVRE DES SYNDROMES SUPPLÉMENTAIRES**

VERFAHREN ZUR MAXIMIERUNG DER DECODIERKAPAZITÄT EINES FEHLERKORREKTURCODES UNTER VERWENDUNG ZUSÄTZLICHER SYNDROME

METHOD FOR MAXIMISING THE DECODING CAPACITY OF AN ERROR CORRECTING CODE USING SUPPLEMENTARY SYNDROMES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.12.2011 FR 1161124**

(43) Date de publication de la demande:
**08.10.2014 Bulletin 2014/41**

(73) Titulaire: **Commissariat à l'Énergie Atomique et aux Énergies Alternatives**
**75015 Paris (FR)**

(72) Inventeurs:
• **EVAIN, Samuel**
**91191 Gif Sur Yvette (FR)**
• **GHERMAN, Valentin**
**91120 Palaiseau (FR)**

(74) Mandataire: **Delaval, Guillaume Laurent et al**
**Marks & Clerk France**
**Immeuble Visium**
**22, avenue Aristide Briand**
**94117 Arcueil Cedex (FR)**

(56) Documents cités:
FR-A1- 2 887 378     US-A- 4 397 022
US-A1- 2005 154 966     US-A1- 2007 214 402
US-A1- 2010 017 684

• **BACCARINI L ET AL: "Error-correction techniques and adaptive linearization in SDH radio", EUROPEAN CONFERENCE ON RADIO RELAY SYSTEMS, EDINBURGH, OCT. 11 - 14, 1993, LONDON, IEE, GB, vol. CONF. 4, octobre 1993 (1993-10), pages 238-243, XP006513627, ISBN: 978-0-85296-594-8**
• **WILLIAM EDWARD CHEROWITZO: 'Decoding Linear Codes', [en ligne] 24 Mai 2005, pages 1 - 17, XP055242543 Extrait de l'Internet: <URL:http://www-math.ucdenver.edu/~wcherow i /courses/m7823/decoding.pdf> [extrait le 2016-01-19]**
• **CHEROWITZO: 'Math 4410 - Mathematical Coding Theory - Lecture Notes Fall 2009', [en ligne] 24 Mai 2005, XP055242548 Extrait de l'Internet: <URL:http://www-math.ucdenver.edu/~wcherow i /courses/m7823/m7823f.html> [extrait le 2016-01-19]**

EP 2 786 497 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'invention a pour objets un procédé de génération d'un code correcteur linéaire maximisé, un procédé et dispositif de décodage d'un tel code. Elle s'applique notamment aux domaines des codes correcteurs d'erreurs et des technologies nanométriques.

Dans un système numérique, les données sont habituellement enregistrées dans une mémoire numérique sous forme de valeurs binaires appelées bits. Des erreurs peuvent apparaître sur les données mémorisées et peuvent être transitoires ou permanentes, comme explicité ci-après. Si ces erreurs ne sont pas corrigées ou masquées, elles peuvent engendrer des erreurs de fonctionnement et finalement la défaillance du système.

Les erreurs transitoires sont produites par des interférences avec l'environnement ou sont dues aux caractéristiques intrinsèques des mémoires produites à l'aide des technologies nanométriques.

Les erreurs permanentes sont la conséquence de défauts de la structure physique des circuits, ces défauts apparaissant pendant la production des circuits et/ou à cause du vieillissement. Une densité élevée de défauts matériels dans un système de mémorisation se traduit par un nombre important d'erreurs permanentes.

Afin de garantir un niveau d'intégrité des données mémorisées acceptable et/ou pour augmenter le rendement de production, certains systèmes électroniques utilisent des codes, désignés habituellement par l'acronyme ECC venant de l'expression anglo-saxonne « Error Correcting Codes » ou EDAC pour « Error Detection And Correction » codes.

Dans des mémoires numériques bénéficiant d'une protection de type ECC, les données sont encodées lors de l'écriture desdites données dans la mémoire. Lors de l'encodage de données avec un code ECC, des bits de vérification appelés aussi bits de redondance, sont ajoutés aux bits de données afin de former des mots de code.

Les mots de code d'un code correcteur linéaire sont définis à l'aide d'une matrice de parité H. Un vecteur binaire V est un mot de code seulement si son produit avec la matrice H génère un vecteur nul.

Lors de la lecture des données présentes dans une mémoire, chaque mot de code linéaire V est vérifié en évaluant le produit matriciel $H \cdot V$. Le résultat de cette opération est un vecteur appelé aussi syndrome. Si le syndrome est un vecteur nul, le mot de code est considéré comme correct. Un syndrome non-nul indique la présence d'au moins une erreur. Si le syndrome permet d'identifier les positions des bits affectés, le mot de code est corrigé.

Différents codes ECC linéaires peuvent être mis en oeuvre avec des capacités de détection et de correction d'erreurs différentes. A titre d'exemple, le codage de Hamming permet de corriger une erreur simple, c'est-à-dire une erreur qui affecte un seul bit. Cette capacité de correction est qualifiée de SEC, acronyme venant de l'expression anglo-saxonne « Single Error Correction ».

Un autre exemple de code ECC est le code DEC, acronyme venant de l'expression anglo-saxonne «Double Error Correction». Un code DEC permet la correction d'erreurs doubles, c'est-à-dire d'erreurs affectant deux bits dans un mot de code. Bien évidement, les codes de cette famille sont aussi capables de corriger une erreur simple.

La capacité de correction théoriquement atteignable des codes ECC habituellement utilisés est rarement utilisée. Cela est dû au fait que le nombre N de bits de données dans un mot de code stocké dans une mémoire est habituellement une puissance de 2. En d'autres termes, $N = k * 2^n$ expression dans laquelle n et k sont des entiers. N est donc un multiple d'une puissance de 2.

A titre d'illustration, si un code SEC est utilisé, le nombre c de bits de vérification doit remplir la condition suivante :

$$2^c - 1 \geq N + c \qquad (1)$$

Si les mots de données à protéger sont tels que N = 32, alors le nombre de bits de vérification requis est c = 6.

Le nombre $\Delta$ de syndromes non utilisés par un code SEC linéaire pour la correction d'erreurs simples peut être déterminé en utilisant l'expression suivante :

$$\Delta = 2^c - N - c - 1 \qquad (2)$$

Dans le cas du code SEC pris en exemple, ce nombre de syndromes non utilisés est $\Delta$ = 25.

Ce nombre $\Delta$ de syndromes non utilisés signifie que jusqu'à $\Delta$ erreurs multiples différentes peuvent être corrigées en plus des erreurs simples pouvant être corrigées par le code SEC.

Plus généralement, le nombre $\Delta$ de syndromes non utilisés par un code ECC linéaire en tant que syndromes permettant la correction d'un nombre EC d'erreurs simples ou multiples peut être déterminé en utilisant l'expression suivante :

$$\Delta = 2^c - EC - 1 \qquad\qquad (3)$$

Dans le cas d'un code DEC utilisé pour protéger des mots comprenant N = 32 bits de données, l'utilisation de 12 bits de vérification est nécessaire. Un mot de code a donc une taille de 44 bits. En conséquence, un code DEC doit pouvoir corriger 44 erreurs simples et (43 x 44)/2 = 946 erreurs doubles. Par conséquent, un nombre de EC = 990 erreurs simples et doubles sont corrigeable et l'expression (3) indique que la capacité de correction non-utilisée est de $\Delta = 2^{12}$ - 990 - 1 = 3105 erreurs.

Pour un nombre de bits de vérification donné, la capacité de correction théoriquement atteignable n'étant pas entièrement utilisée. Ainsi, la marge restante peut être exploitée afin de permettre la correction de certaines erreurs supplémentaires. Dans la description, l'expression code de base désigne un code linéaire ECC que l'on cherche à modifier en améliorant sa capacité de correction. Cette amélioration est rendue possible en mettant en oeuvre un mécanisme de correction d'erreurs dites supplémentaires. Une erreur supplémentaire désigne une erreur qui n'est pas corrigée par le code de base mais qui l'est une fois que ledit code a été amélioré.

Ainsi, certaines erreurs doubles peuvent être corrigées dans le cas des codes SEC et certaines erreurs triples peuvent être corrigées dans le cas des codes DEC.

Des codes SEC permettant la correction d'erreurs simples ainsi que la correction d'un nombre restreint d'erreurs doubles ont fait notamment l'objet de plusieurs brevets. On peut citer à titre d'exemple les brevets US3755779 et US3328759 dans lesquels sont décrits des méthodes de codage où un bit supplémentaire de vérification est ajouté par rapport au nombre de bits de vérification nécessaire à l'implémentation d'un code SEC traditionnel. Dans ces exemples, les erreurs doubles affectant des paires de bits de positions adjacentes sont corrigées. La capacité de correction théoriquement atteignable est cependant loin d'être entièrement utilisée.

Une note de cours de l'université du Colorado, intitulée "Decoding Linear Codes", publiée sur internet et archivée le 5 Juillet 2010 (cf.https://web.archive.org/web/*/http://www-math.ucdenver.edu/~wcherowi/courses/m7823/decoding.pdf), divulgue un procédé de décodage par syndrome d'un code de longueur 5 utilisant un tableau standard comprenant six lignes associées à six syndromes et chacune correspondant à un décodage de zéro ou une erreur, le tableau standard comprenant en outre deux lignes supplémentaires associées à deux syndromes supplémentaires pour corriger deux motifs d'erreurs doubles.

Des codes DEC permettant la correction d'erreurs simples, doubles ainsi que la correction d'un nombre restreint d'erreurs affectant plus de deux bits ont été proposés dans l'article de S. Shamshiri et K.-T. Cheng Error-locality-aware linear coding to correct multi-bit upsets in SRAM, IEEE International Test Conference, 2010. L'utilisation de ce type de codes permet la correction d'erreurs impliquant plus de deux bits de positions adjacentes dans le mot de code ou d'erreurs présentes dans un groupe restreint de bits de positions adjacentes. La aussi, la capacité de correction théoriquement atteignable est loin d'être atteinte. Les demandes de brevet, publiés respectivement sous les numéros US 2005/154966 A1 et FR 2 887 378 A1, décrivent des codes correcteurs dont la capacité de correction a été légèrement améliorée, laissant de la marge pour des améliorations supplémentaires.

US 2005 /154966 divulgue un procédé comprenant une première étape de correction d'un paquet de deux erreurs effectuée lorsque les neuf premiers bits du syndrome sont nuls et dans le cas contraire, une deuxième étape corrigeant en un paquet de deux erreurs et une erreur isolée. FR 2 887 378 décrit un procédé de décodage de codes algébriques au delà de la demi-distance du code. Une liste de mots décodés candidats est générée et l'un des candidats est sélectionné en fonction de sa distance Euclidienne au mot reçu. Un but de l'invention est notamment de pallier les inconvénients précités. A cet effet l'invention a pour objet un procédé d'amélioration d'un procédé ou d'un dispositif de décodage de base selon la revendication 1.

Selon un aspect de l'invention, l'étape de sélection peut utiliser un critère de choix d'au moins une erreur par syndrome supplémentaire, l'erreur sélectionnée étant associée à une probabilité d'occurrence plus importante que la probabilité d'occurrence des autres erreurs associées au même syndrome supplémentaire.

Selon un autre aspect de l'invention, l'étape de sélection peut utiliser un critère de choix d'au moins une erreur par syndrome supplémentaire, l'erreur sélectionnée étant choisie parmi les erreurs associées à un même syndrome supplémentairede sorte que le nombre de bits du mot de code affecté par cette erreur soit minimal.

Selon un autre aspect de l'invention, l'étape de sélection peut utiliser un critère de choix d'au moins une erreur parmi les erreurs associées à un même syndrome supplémentairede sorte que le nombre de bits de données du mot de code affecté par cette erreur soit minimal.

Dans un mode de réalisation, l'étape de sélection utilise un critère de choix d'une erreur parmi les erreurs associées à un même syndrome supplémentaire de manière à ce que tous les bits de données ou tous les bits du mot de code soient affectés par le même nombre d'erreurs.

L'invention a notamment comme avantage d'améliorer la capacité de correction des codes linéaires ECC utilisés habituellement pour protéger les données stockées dans une mémoire sans que le nombre de bits de vérification soit augmenté.

D'autres caractéristiques et avantages de l'invention apparaîtront à l'aide de la description qui suit, donnée à titre illustratif et faite en regard des dessins annexés parmi lesquels :

* la figure 1 donne un exemple de matrice de parité H associée à un code correcteur de type SEC et des syndromes non utilisés pour la correction des erreurs simples ;
* la figure 2 donne un exemple de matrice de parité H associée à un code correcteur d'erreur de type DEC et d'un syndrome non-utilisé pour la correction des erreurs simples ou doubles ;
* la figure 3 donne un exemple de procédé de génération d'un code correcteur linéaire maximisé ;
* la figure 4 donne un exemple de dispositif de décodage d'un code correcteur linéaire maximisé.

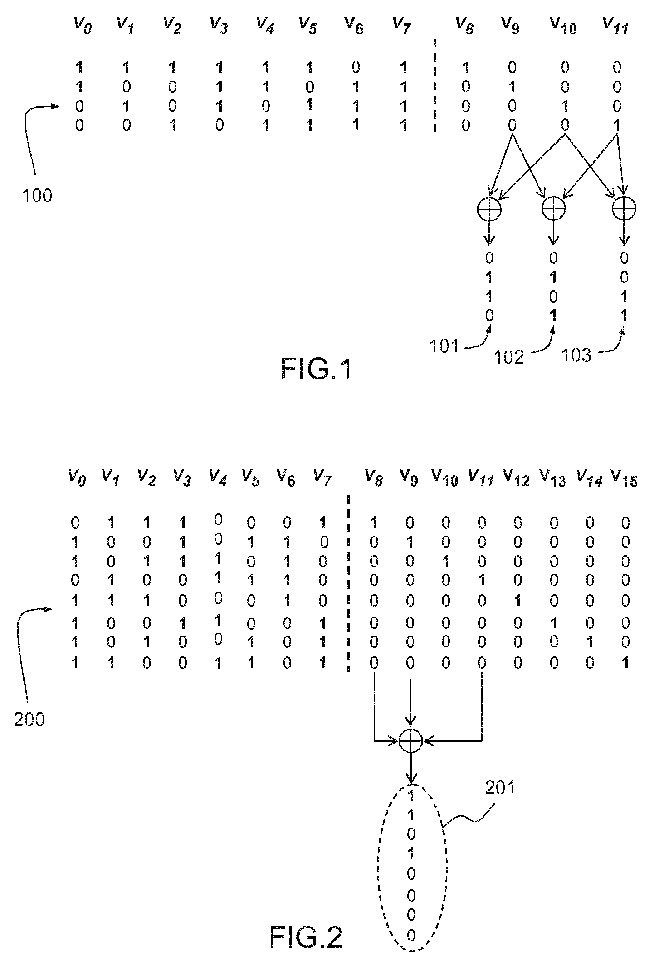

La figure 1 donne un exemple de matrice de parité H 100 associée à un code correcteur de type SEC et des syndromes non utilisés pour la correction des erreurs simples. Le code mis en oeuvre à l'aide de cette matrice assure la correction des erreurs simples pouvant survenir sur tous les bits du mot de code. Chacune des colonnes de la matrice correspond au syndrome d'une erreur simple affectant le bit du mot de code ayant la position correspondante, c'est-à-dire le bit du mot de code avec le même index que la colonne de la matrice.

Dans cet exemple, un mot de code comprend c = 4 bits de vérification et N = 8 bits de données. Les huit bits de données d'un mot de code sont notés de $V_0$ à $V_7$ et les quatre bits de vérification de $V_8$ à $V_{11}$.

L'utilisation de l'expression (2) montre qu'il est possible de corriger jusqu'à $\Delta = 3$ erreurs multiples supplémentaires en plus des erreurs simples pouvant être déjà corrigées. Il est par exemple possible de choisir de corriger les erreurs supplémentaires suivantes :

* l'erreur double affectant les bits $V_9$ et $V_{10}$ et correspondant à l'un des trois syndromes non utilisés 101 ;
* l'erreur double affectant les bits $V_9$ et $V_{11}$ et correspondant à un autre des trois syndromes non utilisés 102 ;
* l'erreur double affectant les bits $V_{10}$ et $V_{11}$ et correspondant à un autre des trois syndromes non utilisés 103.

En résumé, en plus de la correction d'erreurs simples affectant le mot de code, trois erreurs doubles sont corrigeables sur les soixante six erreurs doubles possibles.

La figure 2 donne un exemple de matrice de parité H 200 associée à un code correcteur d'erreur de type DEC et d'un syndrome non-utilisé pour la correction des erreurs simples ou doubles. Ce code permet la correction d'erreurs simples et d'erreurs doubles pouvant affecter tous les bits des mots de code. Dans cet exemple, les mots de code ont une longueur de seize bits et comprennent N = 8 bits de données $V_0$ à $V_7$ et c = 8 bits de vérification $V_8$ à $V_{15}$. Il y a donc seize erreurs simples et cent-vingt erreurs doubles possibles. Chacune des colonnes de la matrice 200 correspond au syndrome de l'erreur simple qui peut affecter un des seize bits du mot de code. Les syndromes permettant d'identifier les erreurs multiples sont donnés par la somme modulo-2, c'est-à-dire bit par bit, des colonnes de la matrice 200 correspondant aux positions des bits corrompus.

A partir de l'expression (3), on peut calculer pour ce type de code la différence $\Delta = 2^8 - 136 - 1 = 119$ qui correspond aux syndromes non utilisés en tant que syndromes visant à corriger les seize erreurs simples et les cent-vingt erreurs doubles ou à identifier le cas sans erreur.

Ainsi jusqu'à $\Delta = 119$ erreurs multiples différentes peuvent être potentiellement corrigées sur les cinq cent soixante erreurs triples possibles. Parmi ces erreurs, on peut par exemple choisir de corriger l'erreur triple pouvant affecter les bits $V_8$, $V_9$ et $V_{11}$ et correspondant au syndrome 201.

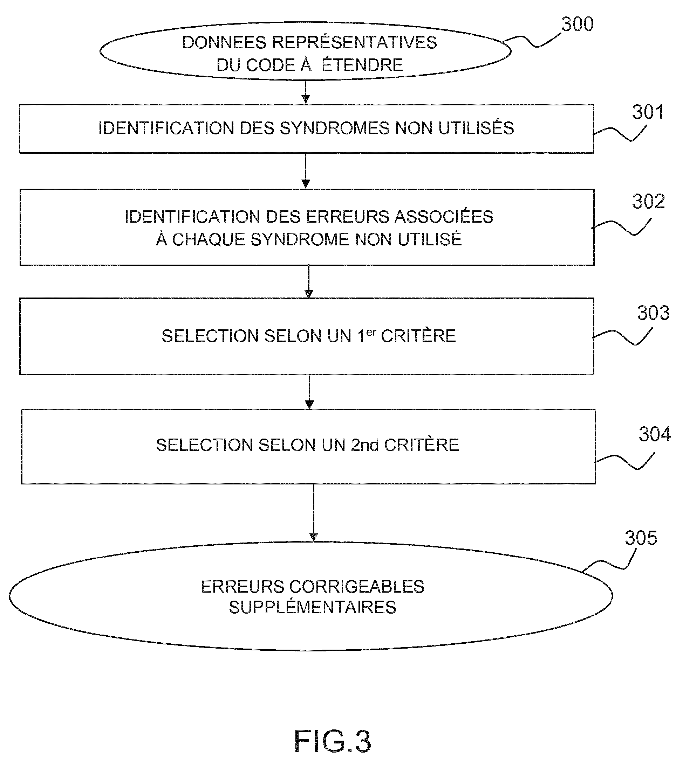

La figure 3 donne un exemple de procédé de génération d'un code correcteur linéaire maximisé à partir d'une matrice de parité H donnée.

Ce procédé permet d'améliorer la capacité de correction d'un code de base. La capacité de correction du code avant amélioration est appelé capacité de correction de base.

Le principe essentiel de ce procédé est d'associer des erreurs supplémentaires à corriger à toutes ou une partie des syndromes qui ne sont pas utilisés par le code de base.

La manière d'associer un syndrome non utilisé à une erreur supplémentaire à corriger peut s'appuyer sur l'utilisation d'un ou plusieurs critères de choix. En effet, des erreurs différentes affectant un mot de code peuvent mener après multiplication dudit mot avec la matrice de parité H au même syndrome non utilisé. Pour que ce syndrome soit utilisé une de ces erreurs supplémentaires devra être sélectionnée en utilisant par exemple un ou plusieurs critères définis par la suite.

Le procédé utilise comme entrées 300 la matrice de parité H du code de base pour lequel l'on veut étendre la capacité de correction ainsi que des informations relatives à ce code, comme par exemple la capacité de correction de base et la liste des erreurs déjà corrigeables.

Une première étape 301 du procédé vise à identifier les syndromes utilisés par le code de base et à identifier les syndromes non utilisés en vue de la correction d'erreurs supplémentaires. Lesdits syndromes non utilisés peuvent être mémorisés 301 dans une liste Lsynd par exemple.

Dans une deuxième étape 302 du procédé, pour chaque syndrome de la liste Lsynd, une liste Lerr des erreurs supplémentaires générant ce syndrome est construite. Il y a donc autant de liste Lerr que de syndromes non utilisés contenus dans la liste Lynd.

Pour chaque syndrome de la liste Lsynd, l'une des erreurs identifiée dans la liste Lerr correspondante est ensuite sélectionnée, l'erreur ainsi sélectionnée correspondant à une erreur supplémentaire corrigeable. Cette sélection peut être réalisée en utilisant différents critères.

Il est possible d'appliquer un unique critère ou plusieurs critères de sélection combinés entre eux, ces critères devant être appliqués de manière à identifier une unique erreur supplémentaire pour chaque syndrome non utilisé. Ainsi, lors du décodage, les syndromes non utilisés permettent de corriger des erreurs qui n'étaient pas prises en compte par le code de base. Le code de base linéaire ECC est alors maximisé, c'est-à-dire que le code ainsi dérivé dudit code de base présente une capacité de correction optimisée proche du maximum théorique.

Des exemples de critères pouvant être appliqués sont donnés ci-après.

Un premier critère de sélection d'une ou plusieurs erreurs associées à un syndrome non utilisé présent dans la liste Lsynd est de trouver la ou les erreurs dans la liste Lerr qui ont la plus grande probabilité d'apparition. L'utilisation de ce critère présuppose que l'on possède des informations statistiques sur l'occurrence des erreurs.

Un deuxième critère de sélection d'une ou plusieurs erreurs associées à un syndrome non utilisé dans la liste Lsynd est de garder dans la liste Lerr seulement les erreurs qui affectent un nombre minimum de bits du mot de code.

Un troisième critère de sélection d'une ou plusieurs erreurs associées à un syndrome non utilisé est de ne sélectionner que les erreurs de la liste Lerr qui affectent le moins de bits de données possible. Les erreurs qui ne sont pas prises en compte par le code de base et affectant seulement les bits de vérification peuvent être ignorées.

Un quatrième critère de sélection des erreurs associées aux syndromes non utilisés est de choisir une erreur dans chaque liste Lerr de manière à ce que tous les bits de données ou tous les bits du mot de code soient affectés par le même nombre d'erreurs. Comme le troisième critère, le but est de minimiser la latence du décodeur du code ECC maximisé.

Dans l'exemple de la figure 3, deux étapes 303, 304 sont appliquées de manière à appliquer successivement deux critères de sélection d'erreurs supplémentaires. Ces deux critères consistent par exemple dans un premier temps 303 à la sélection des erreurs qui affectent un nombre minimum de bits du mot de code, puis dans un second temps 304 en une sélection parmi les erreurs restantes des erreurs ou de l'erreur affectant un nombre minimum de bits de données. Le quatrième critère peut ensuite être appliqué aux listes Lerr qui ont plus d'un élément.

Le résultat de l'application du procédé est une liste de syndromes non utilisés auxquels sont associées des erreurs supplémentaires corrigeables. Un code correcteur ECC maximisé a ainsi été construit.

Avantageusement, les erreurs supplémentaires associées aux syndromes non utilisés peuvent être des erreurs qui affectent plus de bits que les erreurs multiples déjà corrigeables par le code ECC de base.

Le code peut être construit en sélectionnant une matrice H de manière à ce qu'une classe particulière d'erreurs multiples corresponde à des syndromes non-utilisés par le code ECC de base. Ainsi, lorsque le procédé de génération d'un code correcteur linéaire ECC maximisé est utilisé, ces erreurs multiples vont se retrouver dans les listes Lerr, ce qui permettra leur sélection, selon les critères de sélections utilisés.

Avantageusement, l'architecture d'un composant mémoire utilisant un code de base pour protéger ses données mémorisées ne nécessite pas de modification pour mettre en oeuvre le code ECC maximisé.

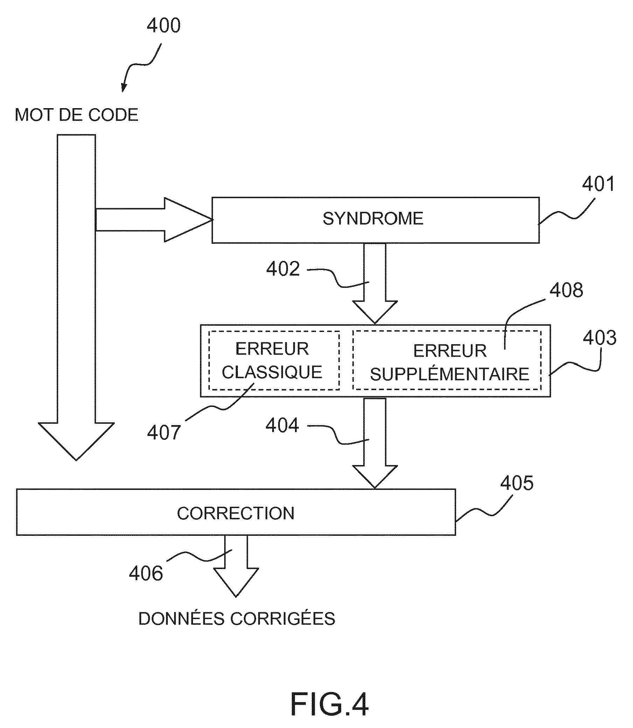

La figure 4 donne un exemple de dispositif de décodage d'un code correcteur linéaire ECC maximisé. Les bits des mots de code 400 sont utilisés en entrée du dispositif pour la génération 401 des syndromes d'erreur 402. Les bits des syndromes 402 sont ensuite utilisés pour l'identification 403 des erreurs à corriger. Un syndrome 402 peut être un syndrome classique, c'est-à-dire un syndrome permettant la correction d'une erreur corrigeable par le code de base. Un syndrome 402 peut aussi être un syndrome non utilisé. Ainsi, le dispositif de décodage comprend des moyens pour identifier si le syndrome est un syndrome non utilisé par un code de base et donc d'identifier si le mot de code comprend une erreur classique 407 ou bien une erreur supplémentaire 408.

Cette identification se traduit par un mot 404 dont les bits indiquent les inversions de valeur des bits à réaliser 405 sur le mot de code 400 afin d'obtenir un mot de code corrigé 406 ou seulement des bits de données corrigés.

Dans un tel dispositif, tous ou seulement une partie des syndromes non utilisés par le code de base peuvent être employés afin de permettre la correction des erreurs supplémentaires.

## Revendications

1. Procédé d'amélioration d'un procédé ou d'un dispositif de décodage de base d'erreurs affectant des mots de code d'un code correcteur linéaire associé à une matrice de parité H, le décodage de base étant associé à une liste de syndromes utilisés qui permettent de corriger des erreurs corrigeables, ledit procédé d'amélioration comprenant :

- une première étape (301) d'identification du ou des syndromes non utilisés pour le décodage de base, lesdits syndromes appelés syndromes supplémentaires étant utilisés pour le procédé amélioré du décodage de base;
- une deuxième étape (302) d'identification des erreurs pouvant affecter les mots de codes et permettant d'obtenir lesdits syndromes supplémentaires lorsqu'un mot de code est multiplié par la matrice H ;
- une troisième étape de sélection (303, 304) d'une unique erreur pour chaque syndrome supplémentaire parmi les erreurs identifiées (302), ladite erreur étant appelée erreur supplémentaire,

les première, deuxième et troisième étapes (301 ; 302, 303, 304) étant mises en oeuvre avant l'exécution du décodage de base amélioré.

2. Procédé selon la revendication 1 dans lequel l'étape de sélection utilise un critère de choix d'au moins une erreur par syndrome supplémentaire, l'erreur sélectionnée étant associée à une probabilité d'occurrence plus importante que la probabilité d'occurrence des autres erreurs associées au même syndrome supplémentaire.

3. Procédé selon l'une des revendications précédentes dans lequel l'étape de sélection utilise un critère de choix d'au moins une erreur par syndrome supplémentaire, l'erreur sélectionnée étant choisie parmi les erreurs associées à un même syndrome supplémentaire de sorte que le nombre de bits du mot de code affecté par cette erreur soit minimal.

4. Procédé selon l'une des revendications précédentes dans lequel l'étape de sélection utilise un critère de choix d'au moins une erreur parmi les erreurs associées à un même syndrome supplémentaire de sorte que le nombre de bits de données du mot de code affecté par cette erreur soit minimal.

5. Procédé selon l'une des revendications précédentes dans lequel l'étape de sélection utilise un critère de choix d'une erreur parmi les erreurs associées à un même syndrome supplémentaire de manière à ce que tous les bits de données ou tous les bits du mot de code soient affectés par le même nombre d'erreurs.

**Patentansprüche**

1. Verfahren zum Verbessern eines Verfahrens oder einer Vorrichtung zum Basisdecodieren von Fehlern, die Codewörter eines linearen Korrekturcodes beeinflussen, assoziiert mit einer Matrix mit Parität H, wobei die Basisdecodierung mit einer Liste von benutzten Syndromen assoziiert ist, die eine Korrektur von korrigierbaren Fehlern zulässt, wobei das Verbesserungsverfahren Folgendes beinhaltet:

- einen ersten Schritt (301) des Identifizierens des einen oder der mehreren nicht für die Basisdecodierung benutzten Syndrome, wobei die ergänzende Syndrome genannten Syndrome für das verbesserte Basisdecodierungsverfahren benutzt werden;
- einen zweiten Schritt (302) des Identifizierens von Fehlern, die die Codewörter beeinflussen können und die es zulassen, die ergänzenden Syndrome zu erhalten, wenn ein Codewort mit der Matrix H multipliziert wird;
- einen dritten Schritt des Auswählens (303, 304) eines einzigen Fehlers für jedes ergänzende Syndrom aus den identifizierten Fehlern (302), wobei der Fehler als ergänzender Fehler bezeichnet wird,

wobei der erste, zweite und dritte Schritt (301; 302, 303, 304) vor dem Ausführen der verbesserten Basisdecodierung durchgeführt werden.

2. Verfahren nach Anspruch 1, bei dem der Auswahlschritt ein Auswahlkriterium von wenigstens einem Fehler pro ergänzendem Syndrom benutzt, wobei der gewählte Fehler mit einer höheren Auftretenswahrscheinlichkeit assoziiert ist als die Auftretenswahrscheinlichkeit der anderen Fehler, die mit demselben ergänzenden Syndrom assoziiert sind.

3. Verfahren nach einem der vorherigen Ansprüche, bei dem der Auswahlschritt ein Auswahlkriterium von wenigstens einem Fehler pro ergänzendem Syndrom benutzt, wobei der gewählte Fehler aus den Fehlern ausgewählt ist, die mit einem selben ergänzenden Syndrom assoziiert sind, so dass die Anzahl von Bits des durch diesen Fehler beeinflussten Codeworts minimal ist.

4. Verfahren nach einem der vorherigen Ansprüche, bei dem der Auswahlschritt ein Auswahlkriterium von wenigstens einem Fehler aus den Fehlern benutzt, die mit einem selben ergänzenden Syndrom assoziiert sind, so dass die Anzahl von Bits von Daten des durch diesen Fehler beeinflussten Codeworts minimal ist.

5. Verfahren nach einem der vorherigen Ansprüche, bei dem der Auswahlschritt ein Auswahlkriterium von einem Fehler aus den Fehlern benutzt, die mit einem selben ergänzenden Syndrom assoziiert sind, so dass alle Bits von Daten oder alle Bits des Codeworts durch dieselbe Anzahl von Fehlern beeinflusst werden.

**Claims**

1. A method for enhancing a method or a device for base decoding errors affecting code words of a linear correcting code associated with a parity matrix H, the base decoding being associated with a list of used syndromes that allow correctable errors to be corrected, said enhancing method comprising:

   - a first step (301) of identifying the one or more syndromes not used for the base decoding, said syndromes being called additional syndromes and being used for the enhanced base decoding method;
   - a second step (302) of identifying errors that can affect the code words and can allow said additional syndromes to be obtained when a code word is multiplied by said matrix H;
   - a third step (303, 304) of selecting a single error for each additional syndrome from among the errors identified (302), said error being called additional error,

   said first, second and third steps (301, 302, 303, 304) being implemented before the execution of the enhanced decoding base.

2. The method according to claim 1, wherein said selection step uses a criterion of selecting at least one error per additional syndrome, the selected error being associated with a probability of occurrence that is greater than the probability of occurrence of the other errors associated with the same additional syndrome.

3. The method according to any one of the preceding claims, wherein said selection step uses a criterion for selecting at least one error per additional syndrome, the selected error being selected from among the errors associated with the same additional syndrome, so that the number of bits of the code word affected by this error is minimal.

4. The method according to any one of the preceding claims, wherein said selection step uses a criterion for selecting at least one error from among the errors associated with the same additional syndrome, so that the number of data bits of the code word affected by this error is minimal.

5. The method according to any one of the preceding claims, wherein said selection step uses a criterion for selecting one error from among the errors associated with the same additional syndrome, so that all of the data bits or all of the bits of the code word are affected by the same number of errors.

|  | $V_0$ | $V_1$ | $V_2$ | $V_3$ | $V_4$ | $V_5$ | $V_6$ | $V_7$ | $V_8$ | $V_9$ | $V_{10}$ | $V_{11}$ |
|---|---|---|---|---|---|---|---|---|---|---|---|---|
|  | 1 | 1 | 1 | 1 | 1 | 1 | 0 | 1 | 1 | 0 | 0 | 0 |
|  | 1 | 0 | 0 | 1 | 1 | 0 | 1 | 1 | 0 | 1 | 0 | 0 |
|  | 0 | 1 | 0 | 1 | 0 | 1 | 1 | 1 | 0 | 0 | 1 | 0 |
|  | 0 | 0 | 1 | 0 | 1 | 1 | 1 | 1 | 0 | 0 | 0 | 1 |

100

101
102
103

0    0    0
1    1    0
1    0    1
0    1    1

# FIG.1

|  | $V_0$ | $V_1$ | $V_2$ | $V_3$ | $V_4$ | $V_5$ | $V_6$ | $V_7$ | $V_8$ | $V_9$ | $V_{10}$ | $V_{11}$ | $V_{12}$ | $V_{13}$ | $V_{14}$ | $V_{15}$ |
|---|---|---|---|---|---|---|---|---|---|---|---|---|---|---|---|---|
|  | 0 | 1 | 1 | 1 | 0 | 0 | 0 | 1 | 1 | 0 | 0 | 0 | 0 | 0 | 0 | 0 |
|  | 1 | 0 | 0 | 1 | 0 | 1 | 1 | 0 | 0 | 1 | 0 | 0 | 0 | 0 | 0 | 0 |
|  | 1 | 0 | 1 | 1 | 1 | 0 | 1 | 0 | 0 | 0 | 1 | 0 | 0 | 0 | 0 | 0 |
|  | 0 | 1 | 0 | 0 | 1 | 1 | 1 | 0 | 0 | 0 | 0 | 1 | 0 | 0 | 0 | 0 |
|  | 1 | 1 | 1 | 0 | 0 | 0 | 1 | 0 | 0 | 0 | 0 | 0 | 1 | 0 | 0 | 0 |
|  | 1 | 0 | 0 | 1 | 1 | 0 | 0 | 1 | 0 | 0 | 0 | 0 | 0 | 1 | 0 | 0 |
|  | 1 | 0 | 1 | 0 | 0 | 1 | 0 | 1 | 0 | 0 | 0 | 0 | 0 | 0 | 1 | 0 |
|  | 1 | 1 | 0 | 0 | 1 | 1 | 0 | 1 | 0 | 0 | 0 | 0 | 0 | 0 | 0 | 1 |

200

201

1
1
0
1
0
0
0
0

# FIG.2

DONNEES REPRÉSENTATIVES
DU CODE À ÉTENDRE — 300

↓

IDENTIFICATION DES SYNDROMES NON UTILISÉS — 301

↓

IDENTIFICATION DES ERREURS ASSOCIÉES
À CHAQUE SYNDROME NON UTILISÉ — 302

↓

SELECTION SELON UN 1er CRITÈRE — 303

↓

SELECTION SELON UN 2nd CRITÈRE — 304

↓

ERREURS CORRIGEABLES
SUPPLÉMENTAIRES — 305

FIG.3

400

MOT DE CODE

| SYNDROME | 401

402

| ERREUR CLASSIQUE | ERREUR SUPPLÉMENTAIRE | 408 403

407 404

| CORRECTION | 405

406

DONNÉES CORRIGÉES

FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 3755779 A
- US 3328759 A
- US 2005154966 A1
- FR 2887378 A1
- US 2005154966 A
- FR 2887378

**Littérature non-brevet citée dans la description**

- *Decoding Linear Codes,* 05 Juillet 2010, https://web.archive.org/web/*/http://www-math.ucdenver.edu/~wcherowi/courses/m7823/decoding.pdf
- **S. SHAMSHIRI ; K.-T. CHENG.** Error-locality-aware linear coding to correct multi-bit upsets in SRAM. *IEEE International Test Conference,* 2010